# DEMANDE DE BREVET EUROPEEN

(11) **EP 1 111 669 A1**
(43) Date de publication de la demande: **27.06.2001**
(21) Numéro de dépôt: 00410161.4
(22) Date de dépôt: 22.12.2000
(51) Int. Cl.: H01L 21/768

(54) **Procédé de réalisation d'interconnexions métalliques isolées dans des circuits intégrés**

(30) Priorité: 24.12.1999 FR 9916488
(71) Demandeur: STMicroelectronics SA, 94250 Gentilly (FR); FRANCE TELECOM, 75015 Paris (FR)
(72) Inventeur: Torres, Joaquim, 38950 Saint Martin Le Vinoux (FR); Gayet, Philippe, 38660 Saint Vincent de Mercuze (FR); Haond, Michel, 38920 Crolles (FR)
(74) Mandataire: de Beaumont, Michel

(57) **Abrégé**

L'invention concerne un procédé de formation d'un niveau de métallisation d'un circuit intégré comprenant les étapes consistant à former des zones métalliques (11, 12, 13, 14) d'un niveau de métallisation séparées latéralement par une première couche isolante (6), éliminer la première couche isolante, déposer une deuxième couche isolante (24) de façon non conforme de sorte qu'il se forme des lacunes entre des zones métalliques voisines, ou bien de façon à obtenir une couche poreuse. L'élimination de la première couche isolante (6) est effectuée à travers un masque (16) de façon à laisser en place des zones de garde (21) de la première couche isolante autour des parties des zones métalliques destinées à être contactées par un via traversant la deuxième couche isolante.

## Description

La présente invention concerne la fabrication de circuits intégrés semiconducteurs et plus particulièrement les étapes finales de cette fabrication au cours desquelles on réalise, au-dessus d'un substrat de silicium comportant des régions diffusées et des structures choisies, une succession de couches isolantes alternées avec des couches métalliques. Chacune des couches métalliques constitue un niveau de métallisation. Chaque niveau de métallisation est gravé selon une topologie déterminée pour établir des contacts avec des vias reliant cette couche métallique à une couche métallique inférieure et à une couche métallique supérieure. La couche la plus élevée est reliée à des plots de contact et la couche la moins élevée est reliée par des vias à des portions du substrat semiconducteur et/ou des régions de silicium polycristallin.

Il se pose ainsi des problèmes successifs de formation de vias à l'intérieur d'une couche diélectrique, de gravure des couches diélectriques et de gravure des couches métalliques. Divers procédés ont été développés dans la technique pour réaliser de telles couches d'interconnexion et ces procédés sont maintenant bien au point avec des matériaux classiques tels que l'oxyde de silicium et l'aluminium.

Toutefois, tandis que les progrès techniques amènent à réduire les dimensions des composants élémentaires dans le silicium, on est corrélativement amené à réduire les dimensions des motifs formés dans les diverses couches de métallisation et à rapprocher les métallisations les unes des autres. Il en résulte notamment une augmentation des capacités parasites verticales entre couches métalliques de niveaux différents et des capacités parasites latérales entre portions de métallisations d'un même niveau. Pour éviter l'augmentation de la valeur des capacités parasites, qui réduit la vitesse de commutation possible du circuit, on cherche à utiliser des diélectriques ayant des constantes diélectriques plus faibles que celle de l'oxyde de silicium. Toutefois, un inconvénient commun de beaucoup de ces diélectriques est qu'ils sont difficiles à graver.

On a également recherché à utiliser des matériaux conducteurs plus conducteurs que l'aluminium tels que le cuivre. A nouveau, avec de tels éléments, on se retrouve devant de grandes difficultés pour graver ces matériaux de façon localisée, par exemple pour former des tranchées à flancs raides ou isoler électriquement les motifs entre eux.

Ces problèmes ont été résolus notamment par les techniques décrites dans la demande de brevet européen EP-A-0923125 (B3521) qui rappelle également divers procédés connus de formation de structures d'interconnexion.

Pour réduire encore les capacités parasites latérales entre portions de métallisation d'un même niveau on a proposé d'effectuer des dépôts d'isolant de sorte qu'il demeure un vide (une bulle d'air) entre portions de métallisation voisines d'un même niveau. On a également proposé des dépôts d'isolants poreux. Ceci pose de nouveaux problèmes que la présente invention vise à résoudre.

Ainsi, un objet de la présente invention est de prévoir un nouveau procédé de réalisation de structures comprenant plusieurs niveaux conducteurs séparés par des couches isolantes traversées localement par des vias remplis de métal.

Un autre objet de la présente invention est de prévoir un tel procédé dans lequel des pores ou des vides sont ménagés entre métallisations voisines d'un même niveau.

Pour atteindre ces objets ainsi que d'autres, la présente invention prévoit un procédé de formation d'un niveau de métallisation d'un circuit intégré comprenant les étapes consistant à former des zones métalliques d'un niveau de métallisation séparées latéralement par une première couche isolante, éliminer la première couche isolante, déposer une deuxième couche isolante de façon non conforme de sorte qu'il se forme des lacunes entre des zones métalliques voisines, ou bien de façon à obtenir une couche poreuse. L'élimination de la première couche isolante est effectuée à travers un masque de façon à laisser en place des zones de garde de la première couche isolante autour des parties des zones métalliques destinées à être contactées par un via traversant la deuxième couche isolante.

Selon un mode de réalisation de la présente invention, les zones métalliques sont des zones de cuivre, d'argent ou d'or, ou de divers alliages de cuivre avec des matériaux choisis dans le groupe comprenant l'aluminium, le silicium, le manganèse et le cobalt.

Selon un mode de réalisation de la présente invention, la deuxième couche isolante, déposée de façon non conforme de sorte qu'il se forme des lacunes, est en un matériau choisi dans le groupe comprenant l'oxyde de silicium, et des oxydes de silicium dopés au fluor ou au carbone, déposés par voie chimique en phase vapeur.

Selon un mode de réalisation de la présente invention, la deuxième couche isolante, destinée à fournir une couche poreuse, est un aérogel ou un xérogel.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 4 illustrent des étapes successives de formation d'interconnexions par un procédé selon un mode de réalisation de la présente invention ;
la figure 5 représente une phase ultérieure possible de réalisation d'un groupe d'interconnexions selon la présente invention ;
la figure 6 représente une variante de la présente invention ; et
les figures 7 et 8 représentent des variantes des étapes de la présente invention illustrées en figures 2 et 3.

Les diverses figures sont des vues en coupe schématiques et, conformément à l'usage dans le domaine de la représentation des composants semiconducteurs, ne sont pas tracées à l'échelle.

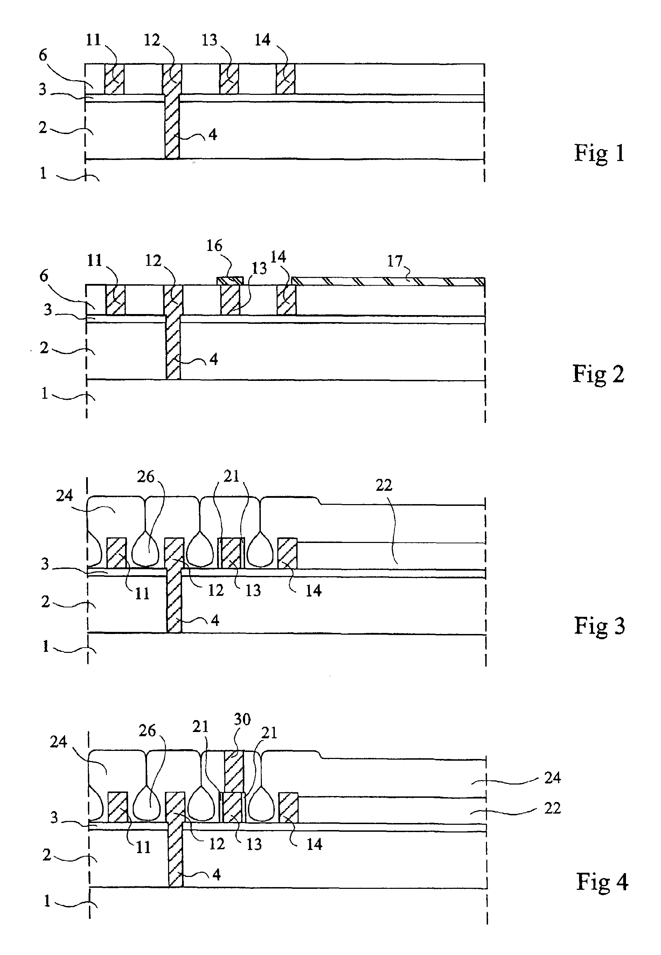

La figure 1 représente une structure d'interconnexion à un stade intermédiaire de fabrication, telle qu'illustrée par exemple dans la demande de brevet susmentionnée en figure 3D ou 4F. Cette structure est formée sur un substrat 1 correspondant à un niveau intermédiaire de fabrication d'un circuit intégré. A titre d'exemple, la partie haute du substrat 1 pourra correspondre à une métallisation s'étendant dans le plan de la figure. Au-dessus du substrat 1 est formée une couche isolante 2, constituée d'un ou plusieurs matériaux isolants et de préférence surmontée d'une couche isolante mince 3 qui peut être gravée sélectivement par rapport à la couche isolante 2. Par exemple, la couche isolante 2 sera en oxyde de silicium et la couche isolante 3 en nitrure de silicium. Toutefois, tout autre ensemble ou couple d'isolants pourra être utilisé. On pourra notamment se référer aux matériaux décrits dans la demande de brevet susmentionnée. Les couches isolantes 2 et 3 sont traversées par une ouverture remplie d'un matériau conducteur 4 constituant un via venant contacter la couche conductrice 1 du niveau inférieur.

Au-dessus de la couche isolante 3 et de la surface supérieure du via 4 est formé un niveau de métallisation. A la figure 1, on a représenté conformément à ce qui a été décrit dans les figures susmentionnées de la demande de brevet européen EP-A-0923125 des portions de métallisation encastrées dans une couche isolante 6. Le choix d'une telle structure comme structure de départ constitue l'un des aspects de la présente invention. Dans la vue en coupe fragmentaire de la figure 1, on a représenté des portions de métallisation 11, 12, 13 et 14 qui correspondent par exemple à des sections de lignes d'interconnexion s'étendant perpendiculairement au plan de la figure. La métallisation 12 vient en contact avec la surface supérieure du via 4. La métallisation 13 est destinée à être contactée par un via formé lors d'une étape ultérieure. Bien entendu, on pourra également prévoir qu'un via soit formé au-dessus de la métallisation 12 elle-même en contact avec le via 4. On comprendra que dans une vue en coupe de l'ensemble d'une puce de circuit intégré, il apparaîtrait un très grand nombre de métallisations semblables à celles illustrées en figure 1. En outre, de façon générale, on trouve sur la surface supérieure d'une puce, d'une part, des zones où existent des métallisations s'étendant parallèlement les unes aux autres et aussi près que possible les unes des autres de façon compatible avec la technologie de fabrication et, d'autre part, des zones, telles que la zone située dans la partie droite de la figure 1, dans lesquelles il n'y a pas de métallisation ou dans lesquelles il y a seulement des métallisations très espacées les unes des autres.

Dans un exemple de réalisation de la présente invention, les vias 4 et/ou le niveau de métallisation comprenant les régions 11 à 14 sont constitués d'une couche d'accrochage en nitrure de tantale et d'une couche d'un métal tel que du cuivre, ou des alliages de cuivre ou d'aluminium, ou encore du tungstène. L'isolant séparant les vias voisins peut être constitué d'une couche d'oxyde de silicium revêtue d'une couche de nitrure de silicium. De même, la couche isolante 6 peut être une couche d'oxyde de silicium éventuellement revêtue d'une couche de nitrure de silicium (non représentée).

De façon générale, la présente invention ne vise pas particulièrement les matériaux décrits ci-dessus mais vise une structure de couches de métallisation du type de celle représentée en figure 1, dans laquelle des parties métalliques sont encastrées dans une couche isolante 6 qui les sépare.

A une étape ultérieure d'un mode de réalisation de la présente invention, on cherche à former des lacunes ou "bulles d'air" entre des métallisations voisines. Pour cela, il faut éliminer la couche isolante 6 entre les lignes de métallisation 11 à 14 voisines. Selon la présente invention, avant de réaliser une gravure sélective d'élimination de l'isolant 6, on procède au dépôt d'une couche de masquage dont des portions 16 et 17 sont représentées en figure 2.

La portion de couche de masquage 16 est disposée à un emplacement où un via doit venir contacter une métallisation, la métallisation 13 dans l'exemple de la figure 2. Cette portion de couche de masquage 16 déborde légèrement latéralement par rapport à la métallisation 13. En fait, on comprendra que le masque servant à former la couche de masquage 16 est semblable au masque qui à l'étape suivante servira à définir les vias. Toutefois le masque servant à former la couche de masquage 16 présente des ouvertures légèrement élargies par rapport au masque des vias.

La portion de couche de masquage 17 recouvre les zones dans lesquelles on ne trouve pas de métallisations proches les unes des autres. Une portion 17 de la couche de masquage sera également prévue entre des métallisations ayant une distance importante entre elles, par exemple une distance double de la distance minimum existant entre les métallisations 11 à 14.

Pour arriver à la structure illustrée en figure 3, on procède d'abord à une gravure anisotrope sélective de la couche isolante 6, de sorte que demeurent en place les métallisations 11 à 14 et les parties 21 et 22 de la couche 6 respectivement disposées sous la couche de masquage 16 et sous la couche de masquage 17. La partie 21 correspond à une zone de garde latérale autour de la portion de la métallisation 13 qui doit être contactée par un via. On dépose ensuite par un procédé non conforme une couche d'un isolant, de façon à obtenir une couche isolante 24 qui comprend des lacunes ou "bulles d'air" 26 entre les métallisations voisines 11-12, 12-13, 13-14.

Du fait du maintien de la couche isolante 22 qui a sensiblement la même hauteur que les métallisations 11, 12, 13, 14, en dehors des régions où il existe des lignes d'interconnexion serrées, la surface supérieure de la couche isolante 24 est sensiblement plane par suite de son dépôt. De plus, on pourra comme cela a été décrit précédemment prévoir une couche isolante supplémentaire (non représentée) au-dessus de la couche isolante 24, par exemple une couche de nitrure de silicium. Cette couche supplémentaire a pour rôle d'indiquer une fin de gravure, et éventuellement de constituer une barrière de diffusion à l'égard de certains matériaux tel que du cuivre.

A l'étape illustrée en figure 4, on creuse des vias dans la couche 24. Ces vias sont remplis d'un métal 30. On voit là l'avantage d'avoir prévu au préalable les zones de garde 21. En effet, en l'absence des zones de garde 21, du fait des défauts d'alignement inévitables, le métal 30 pourrait venir se répandre dans la lacune adjacente 26 et priver le système de tous ses avantages.

Bien entendu, la présente invention est susceptible de diverses variantes et modifications qui apparaîtront à l'homme de métier. Notamment, divers matériaux conducteurs autres que du métal et divers diélectriques pourront être utilisés. Divers procédés de gravure pourront être utilisés.

De plus, la présente invention s'appliquera non seulement à la formation d'un niveau de métallisation, mais également à la formation d'un niveau de vias. En effet, dans le cas où de nombreux vias rapprochés existent, on pourra souhaiter former un isolement à bulles d'air entre vias adjacents.

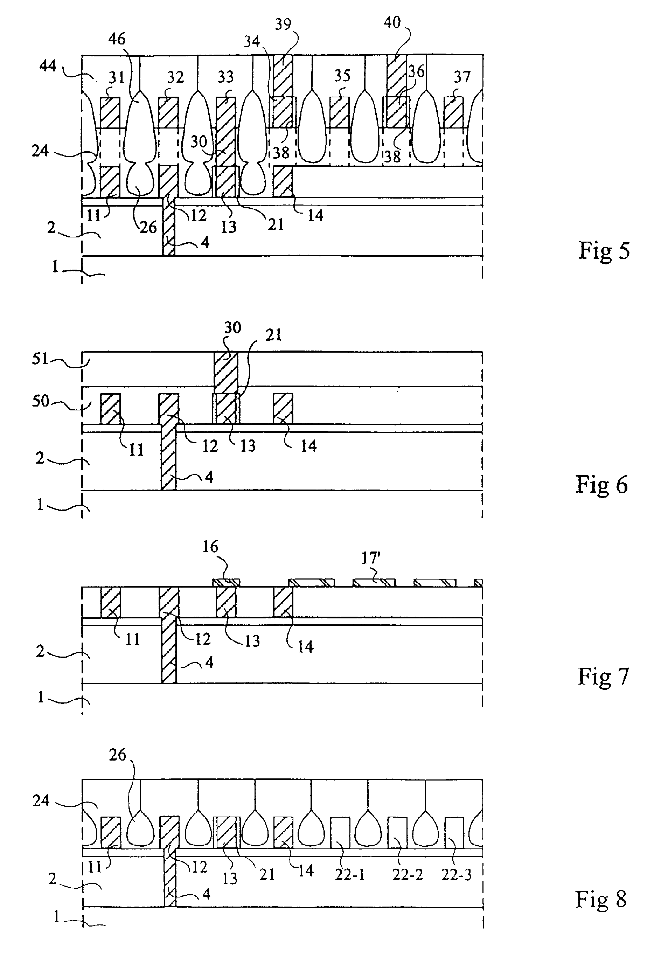

La figure 5 représente un exemple de structure selon la présente invention à un stade ultérieur de fabrication. Dans la partie inférieure de cette figure, on retrouve les éléments illustrés en figure 4. Comme cela est indiqué, la couche isolante 24 peut être surmontée d'une couche mince d'un matériau d'arrêt de gravure, par exemple du nitrure de silicium.

En figure 5, on a représenté un deuxième niveau de métallisation dont on voit dans la figure des portions 31 à 37, la portion 33 venant en contact avec le via 30 et les portions 34 et 36 étant destinées à venir en contact avec des vias formés ultérieurement 39 et 40. Avant de déposer de façon non conforme une couche isolante 44, de la même façon que la couche 24, on procède à une gravure partielle de la couche isolante 24, en utilisant les portions de métallisation 31 à 37 comme masque. On forme ainsi des bulles d'air 46 qui ccmmuniquent avec les bulles 26. Comme dans le cas précédent, les métallisations 34 et 36 auront été entourées de zones de garde 38 d'une couche isolante de nature classique, par exemple de l'oxyde de silicium. On améliore ainsi l'isolement.

La figure 6 représente une autre variante de la présente invention. Selon cette variante, à l'étape de la figure 2, on aura utilisé comme précédemment la portion de masque 16 au-dessus des régions qui doivent être contactées par un via, telles que la région 13. On utilise ce masque pour graver la structure en laissant comme précédemment une zone de garde 21 en un matériau isolant classique tel que l'oxyde de silicium autour de la région 13 dans la zone où cette région doit être contactée par un via. Par contre, la portion de masque 17 n'est pas utilisée. Ensuite, on procède au dépôt d'une couche d'un matériau poreux 50, par exemple un aérogel ou un xérogel. Cette couche 50 est déposée sur une épaisseur suffisante pour combler tout l'espace entre les portions 11-14 d'un niveau de métallisation et déborde éventuellement légèrement par rapport à la hauteur de ce niveau de métallisation. Cette couche est elle-même revêtue d'une couche 51 d'un matériau isolant classique. Le matériau poreux, comme le matériau isolant comprenant des lacunes décrit précédemment, est susceptible de se dégrader fortement si une métallisation le pénètre de façon importante. Par exemple, si le via 30 était formé en l'absence des zones de garde 21, il pourrait y avoir une pénétration latérale résultant de la gravure, au bord de la région de métallisation, formant ainsi un vide, se remplissant ensuite de métal autour ou sur un bord de la métallisation 13. La présence de zones de garde 21 selon la présente invention évite cet inconvénient et permet d'utiliser des matériaux poreux.

Les figures 7 et 8 illustrent deux étapes successives d'une autre variante de la présente invention. La figure 7 représente la structure au même stade que ce qui a été décrit précédemment en relation avec la figure 3. La différence entre les deux figures réside dans la réalisation du masque. La portion de masque 16 est la même que celle de la figure 3. Par contre, au lieu de la portion de masque 17 on utilise une portion de masque 17' présentant des ouvertures au même pas que les métallisations 11, 12, 13, 14. Ainsi, à l'étape suivante, illustrée en figure 8, qui correspond par ailleurs à la figure 3, on trouvera des portions 22-1, 22-2 et 22-3 de la couche isolante 22, par exemple de l'oxyde de silicium, au même pas que les métallisations 11 à 14. Ensuite, quand on dépose la couche 24 de façon non conforme, comme dans le cas de figure 3, il se formera des bulles d'air non seulement entre les métallisations mais également entre les portions de régions d'isolement 22-1 à 22-3. Ceci augmente encore l'isolement latéral de la structure et résout d'une autre manière le problème de la planarisation.

## Revendications

1. Procédé de formation d'un niveau de métallisation d'un circuit intégré comprenant les étapes suivantes :
former des zones métalliques (11, 12, 13, 14) d'un niveau de métallisation séparées latéralement par une première couche isolante (6),
éliminer la première couche isolante,
déposer une deuxième couche isolante (24) de façon non conforme de sorte qu'il se forme des lacunes entre des zones métalliques voisines, ou bien de façon à obtenir une couche poreuse,
caractérisé en ce que l'élimination de la première couche isolante (6) est effectuée à travers un masque (16) de façon à laisser en place des zones de garde (21) de la première couche isolante autour des parties des zones métalliques destinées à être contactées par un via traversant la deuxième couche isolante.

2. Procédé selon la revendication 1, caractérisé en ce que les zones métalliques (11-14) sont des zones de cuivre, d'argent ou d'or, ou de divers alliages de cuivre avec des matériaux choisis dans le groupe comprenant l'aluminium, le silicium, le manganèse et le cobalt.

3. Procédé selon la revendication 1, caractérisé en ce que la deuxième couche isolante, déposée de façon non conforme de sorte qu'il se forme des lacunes, est en un matériau choisi dans le groupe comprenant l'oxyde de silicium, et des oxydes de silicium dopés au fluor ou au carbone, déposés par voie chimique en phase vapeur.

4. Procédé selon la revendication 1, caractérisé en ce que la deuxième couche isolante, destinée à fournir une couche poreuse, est un aérogel ou un xérogel.
